Europäisches Patentamt

European Patent Office

Office européen des brevets

(11) Veröffentlichungsnummer: **0 585 606 A1**

# EUROPÄISCHE PATENTANMELDUNG

(21) Anmeldenummer: **93112112.3**

(51) Int. Cl.5: **B29C 59/16**, //B29K67/00

(22) Anmeldetag: **29.07.93**

(30) Priorität: **03.08.92 DE 4225554**

(43) Veröffentlichungstag der Anmeldung:
**09.03.94 Patentblatt 94/10**

(84) Benannte Vertragsstaaten:
**DE FR GB NL**

(71) Anmelder: **BASF Magnetics GmbH**
**Dynamostrasse 3**
**D-68165 Mannheim(DE)**

(72) Erfinder: **Fischer, Gerd, Dr.**
**Gartenstrasse 7**
**D-6719 Bockenheim(DE)**
Erfinder: **Hagemeyer, Alfred, Dr.**
**An der Froschlache 23**
**W-6700 Ludwigshafen(DE)**
Erfinder: **Hibst, Hartmut, Dr.**
**Branichstrasse 23**
**D-6905 Schriesheim(DE)**
Erfinder: **Richter, Hans Juergen, Dr.**
**Gaisbergstrasse 91**
**D-6900 Heidelberg(DE)**
Erfinder: **Schildberg, Hans-Peter, Dr.**
**Collinistrasse 5**
**D-6800 Mannheim 1(DE)**
Erfinder: **Lazare, Sylvain, Prof. Dr.**
**13, Rue des Arbousiers**
**F-33850 Leognan(FR)**
Erfinder: **Bolle, Matthias**
**4, Avenue de Gradignan, App. 9**
**F-33600 Pessac(FR)**

(74) Vertreter: **Karau, Wolfgang, Dr. et al**
**BASF Aktiengesellschaft,**
**Patentabteilung ZDX - C 6**
**D-67056 Ludwigshafen (DE)**

(54) **Flächige Polyethylenterephthalat-Materialien mit geringer Oberflächenrauhigkeit sowie ein Verfahren zu ihrer Herstellung.**

(57) Die Erfindung betrifft flächige PET-Materialien mit einer geringen Oberflächenrauhigkeit aus feinen, noppenartigen Strukturen im Submikronbereich sowie ein Verfahren zu ihrer Herstellung durch zweifaches sukzessives Bestrahlen der Oberflächen mit polarisiertem und von einem gepulsten Excimerlaser erzeugten UV-Licht mit in einem Winkel von 20 bis 90° zueinander angeordneten Polarisationsebenen. Derart behandelte PET-Filme eignen sich insbesondere als Substratmaterial für ferromagnetische Metalldünnschichten.

Die Erfindung betrifft flächige Polyethylenterephthalat-Materialien mit einer geringen Oberflächenrauhigkeit, ein Verfahren zu ihrer Herstellung durch sukzessives Bestrahlen der Oberflächen mit zwei polarisierten, durch den Zerfall von Excimeren erzeugten UV-Strahlungen sowie die Verwendung derart behandelter Polyethylenterephthalat-Filme als Substratmaterial für ferromagnetische Metalldünnschichten.

Die Ausgestaltung von flächigen Polyethylenterephthalat-Material mit einer definierten Oberflächenrauhigkeit ist bei vielen Verwendungen dieses Materials notwendig. Die Rauhigkeiten bewirken generell eine Verbesserung der Haftung, beispielsweise bei Verklebungen, bei der Bedruckbarkeit oder der Benetzbarkeit. Eine aufgerauhte Oberfläche wirkt sich auch günstig beim Stapeln dieses Materials oder beim Wickeln von entsprechenden Folienbahnen aus. Polyethylenterephthalat (PET)-Folien mit einer definierten Rauhigkeit sind insbesondere für die Herstellung von magnetischen Aufzeichnungsmedien, die aus einem polymeren Substrat, einer auf der Oberfläche des Substrats durch ein PVD-Verfahren (physical vapour deposition) aufgebrachten kohärenten, ferromagnetischen Metalldünnschicht und gegebenenfalls auf der Metallschicht ausgebildeten Schutzschicht bestehen, von großer Wichtigkeit. Durch die Oberflächenrauhigkeit der Folien wird ein geringer Verschleiß der Magnetschicht bei einer tribologischen Beanspruchung durch den Magnetkopf gewährleistet. Dabei kommt es durch die Aufrauhung der Polymeroberfläche auch zu einer Verbesserung der Haftung zwischen Polymer und Magnetschicht. Daneben stellen die mechanische und chemische Stabilität der Metallschicht besondere Anforderungen an die Verfahrensweise. Diese Problemfelder können jedoch nicht isoliert betrachtet werden, da eine wie auch immer geartete Optimierung der mechanischen Eigenschaften der zur Diskussion stehenden magnetischen Aufzeichnungsmedien niemals zu Einbußen auf der Seite der magnetischen, d.h. der die Informationsspeicherung betreffenden Eigenschaften, führen darf.

Die Verringerung des Verschleißes der Magnetschicht durch die tribologische Beanspruchung des Magnetkopfes wird u.a. dadurch erreicht, daß durch die Oberflächenrauhigkeit ein direkter Kontakt des Magnetkopfes mit der Metallschicht auf seiner gesamten, makroskopischen Auflagefläche vermieden wird. Damit dieser Effekt erreicht wird, ist es wichtig, daß der mittlere Abstand der Erhebungen auf der Oberfläche klein ist gegen die Dimensionen der makroskopischen Auflagefläche des Magnetkopfes. Die Höhe der Oberflächenrauhigkeit wird dadurch begrenzt, daß bei zu großer Höhe der Oberflächenrauhigkeit die magnetischen Aufzeichnungs- und Wiedergabe-Eigenschaften der aufgebrachten Schichten durch die Abstandsdämpfung schlecht werden.

Um die gewünschten Eigenschaften der Polymerfolien zur Verwendung als Trägermaterial magnetischer Dünnschichtmedien zu erreichen, werden bisher Folien verwendet, bei denen eine definierte Oberflächenrauhigkeit durch Einbau oder Auftragen von kleinsten Teilchen aus einem inerten Material erzeugt wird (z.B. EP 0 153 853). Diese Folien sind zwar gut geeignet, jedoch erfordert die Herstellung solcher Folien besondere und aufwendige Herstellungstechniken.

Die anderen an sich bekannten Verfahren der Oberflächenbehandlung von Polymeroberflächen im Plasma, durch Glimmentladung, Coronaentladung, Flämmen, chemisches Ätzen oder Ionenbestrahlung vor dem Metallisieren können nie voll befriedigen. Wesentlich hierfür war vor allem die nur ungenügende Kontrollierbarkeit der Energieeinwirkung und/oder Restgassteuerung sowie die auftretende Kontamination durch Zersetzungsprodukte.

Auch die bisher beschriebenen Verfahren der UV-Bestrahlung von Polymeroberflächen mit kontinuierlichen UV-Strahlern wie z.B. Quecksilberdampflampen zur Verbesserung der Lackierbarkeit, zur Verbesserung der Bedruckbarkeit von Polyolefinen (US-A 4 933 123), zur Erhöhung der Haftfestigkeit von Klebstoffen auf Polyethylenterephthalatfolien (JP-A 313 850/1989) ergeben dagegen im Fall von magnetischen Aufzeichnungsmedien mit kohärenten Metallschichten nur eine unzureichende Steigerung der Haftung. Aufgrund der langen Bestrahlungszeiten mit kontinuierlichen UV-Lampen in der Größenordnung einiger Minuten ist der Prozeß sehr zeitintensiv und erlaubt keine großen Verarbeitungsgeschwindigkeiten.

Desweiteren ist bekannt, daß auf der Oberfläche von verstreckten PET-Folien durch die Bestrahlung mit nicht-polarisiertem UV-Licht eines Excimerlaser eine periodische noppenförmige bzw. walzenförmige Struktur erzeugt werden kann (E. Ahrenholz et. al., Appl. Phys. A 53,330 (1991)). Diese Strukturen treten in einem Energiebereich auf, in dem die Laserbestrahlung zu einem Materialabtrag (Laserablation) führt. Die Strukturen haben einen typischen Abstand von einigen $\mu$m und bilden sich erst nach der Bestrahlung der Folien mit mehreren Pulsen (mindestens 3 bis 4) vollständig aus. Der Strukturabstand nimmt mit wachsender Energie und Pulszahl ebenso wie die Höhe der Strukturen zu. Die Höhe dieser Strukturen kann mehrere $\mu$m betragen. Eine Bestrahlung von PET-Materialien mit polarisiertem UV-Excimerlaser-Licht mit etwa 1000 Pulsen und Repetitionsraten von 3 Hz bei Energiedichten, die innerhalb eines schmalen Bereichs unterhalb der Abblationsschwelle liegen, und bei der periodische wellen- oder rollenförmigen Strukturen auf der Oberfläche erhalten wurden, ist ebenfalls bekannt (Bolle et al., Appl. Phys. Lett. 60, 674, 1992). Sowohl die Höhe dieser Strukturen als auch der laterale Abstand sind im allgemeinen für eine Anwendung der so behandelten Folien als Träger für magnetische Dünnschichtmedien zu groß.

Aufgabe der vorliegenden Erfindung war es daher, flächige Polyethylenterephthalat-Materialien mit einer definierten jedoch sehr geringen Oberflächenrauhigkeit bereitzustellen und ein Verfahren anzugeben, das die angegebenen Nachteile nicht aufweist und mit dem solche Oberflächenrauhigkeiten in einfacher Weise und ohne Materialabtrag hergestellt werden können sowie eine Gleichmäßigkeit der Eigenschaften auch auf großen Flächen bei hoher Verfahrensgeschwindigkeit gewährleistet.

Es wurde nun gefunden, daß flächige Polyethylenterephthalat Materialien der gestellten Aufgabe genügen, wenn die Oberflächenrauhigkeit aus diskreten, isolierten, noppenförmigen, quasiperiodischen Strukturen im Submikronbereich bestehen mit lateralen Ausdehnungen der noppenförmigen Erhebungen zwischen 10 und 200 nm, wobei der mittlere Abstand zwischen den einzelnen Noppen nicht mehr als 0,5 μm beträgt.

Gegenstand der Erfindung ist außerdem ein Verfahren zur Herstellung dieser flächigen Polyethylenterephthalat-Materialien mit den wie angegeben definierten Oberflächenrauhigkeiten durch zweifaches, hintereinander ausgeführtes Bestrahlen mit linear polarisierter UV-Strahlung wobei die Polarisationsebenen der beiden zeitlich hintereinander erfolgenden Bestrahlungen eines gepulsten Excimerlaser in einem Wellenlängenbereich von 150 bis 400 nm zueinander einen Winkel von 20 bis 90° bilden.

Die erfindungsgemäß durch die feinrauhe Oberfläche gekennzeichneten PET-Materialien zeichnen sich durch eine homogene Flächendichte isolierter und diskreter Vorsprünge mit den charakteristischen punktförmigen Noppenstrukturen aus. Diese Strukturen haben einen Durchmesser von 10 bis 200 nm, vorzugsweise 10 bis 100 nm. Der mittlere Abstand der noppenförmigen Strukturen beträgt in Abhängigkeit der zu ihrer Erzeugung eingebrachten Energie und Einwirkungsdauer weniger als 0,5 μm, gegebenenfalls unter 300 nm. Die beschriebenen Strukturen in Form feiner Noppen treten, abhängig von der Wellenlänge der UV-Laserstrahlung und des vorliegenden PET-Materials, nur in einem relativ schmalen Fenster der Energiedichte unterhalb der (wellenlängen- und materialabhängigen) Ablationsschwelle auf. Bei einer Wellenlänge von 248 nm (KrF-Excimerlaser) und mehr als 200, vorzugsweise 200 bis 4000 Pulsen/Fläche für die beiden Bestrahlungen entstehen die beschriebenen Strukturen bei PET-Folien und bei dünnen PET-Filmen auf Si-Wafer nur innerhalb des Energiedichtebereichs von 1 bis 15, vorzugsweise 4 bis 15 mJ/cm². Bei der Wellenlänge 193 nm (ArF-Excimerlaser) und mehr als 200, vorzugsweise 200 bis 4000 Pulsen/Fläche für die beiden sukzessiven Bestrahlungen werden bei PET-Folien bei Energiedichten im Bereich von 1 bis 6, vorzugsweise 3 bis 6 mJ/cm² die besagten Noppenstrukturen erzeugt. Die vertikale Höhe der Noppen kann in gewissen Grenzen über die Zahl der eingestrahlten Pulse variiert werden, wobei die Pulszahl bei den jeweils unteren Bereichen der Energiedichte vorzugsweise mehr als 1500 Pulse pro Fläche beträgt. Die erfindungsgemäß hergestellte Noppenstruktur ist viel feiner als die bekannten, viel stärkeren Aufrauhungen, die überwiegend mit nicht-polarisiertem Licht, oberhalb der Ablationsschwelle erzeugt werden. Damit unterscheiden sich diese die erfindungsgemäßen Materialien kennzeichnenden Strukturen in ihrem Aussehen deutlich von den bisher bekannten walzen- oder rollenförmigen Strukturen, die auf bekannte Weise durch UV-Bestrahlung hergestellt werden. Ebenso sind sie in ihrer Größe deutlich von den bisher bekannten noppenförmigen Strukturen verschieden, die durch eine nach dem Stand der Technik vorgenommene UV-Bestrahlung der Oberfläche mit Energiedichten oberhalb der Ablationsschwelle erhalten werden. Sie ähneln vielmehr den durch eine spezielle Oberflächenausrüstung der Materialien (partikelgefüllte Lackschicht) erhaltenen feinen und gleichmäßigen Oberflächenerhebungen mit den gewünschten geometrischen Dimensionen, die aber in ihrem Aufbau, Zusammensetzung und in ihrer Herstellung grundsätzlich verschieden sind von letzteren. Dabei handelt es sich nicht wie in der vorliegenden Erfindung um eine gezielte Modifikation der Oberfläche, sondern um eine zusätzlich aufgebrachte Zwischenschicht aus einem Lack, in den Füllteilchen mit den geeigneten Abmessungen eingebettet sind, also um einen völlig anderen Prozeß.

Durch die Erfindung ist es möglich geworden, daß PET-Materialien die Vorteile einer aufgerauhten Oberfläche aufweisen, nicht jedoch die nach dem Stand der Technik durch eine globale und drastische Aufrauhung der Oberfläche bedingten Nachteile. Die erfindungsgemäßen isolierten feinen Erhebungen mit spezifizierter Flächendichte, d.h. nicht zu dicht liegend, sind in der Anwendung und Handhabung aufgrund der weiter verringerten Kontaktfläche zu Auflagekörpern jedweder Art vorteilhafter als die zusammenhängenden und somit dichteren Wellen- und Rollenstrukturen, die zu einer unerwünschten, wesentlichen höheren Packungsdichte der Vorsprünge führen.

Weitere Vorteile, Einzelheiten und Merkmale des erfindungsgemäßen Materials und des erfindungsgemäßen Verfahrens ergeben sich anhand der nachfolgenden Beschreibung, einiger Ausführungsbeispiele und anhand der Figuren.

Dabei zeigen

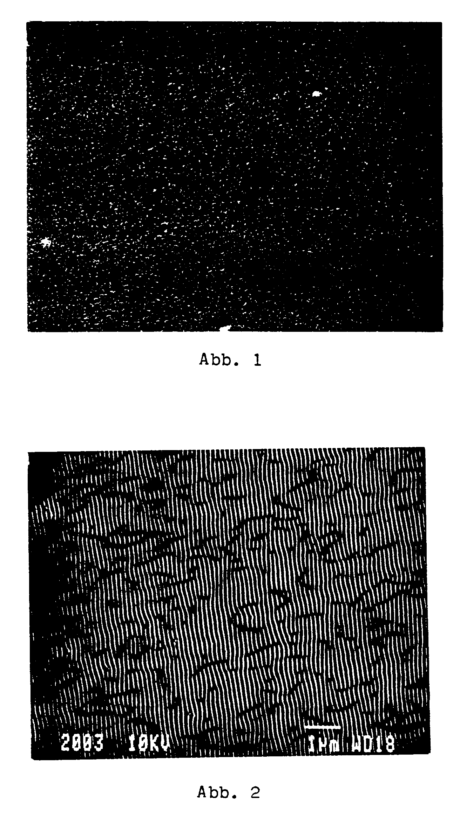

Figur 1    eine unbehandelte PET-Oberfläche,

Figur 2    eine durch einfache Bestrahlung mit polarisierter UV-Excimerlaserstrahlung bei Energiedichten unterhalb der Ablationsschwelle erzeugte wellen- oder rollenförmige Struktur (ripples),

Figur 3     eine erfindungsgemäße PET-Oberfläche mit den feinen noppenförmigen Strukturen (dot pattern).

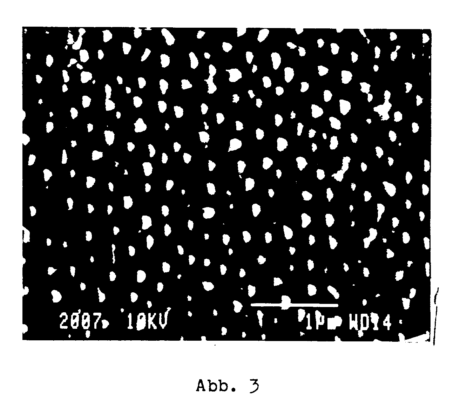

Die in Figur 2 gezeigte Oberfläche wurde durch Bestrahlung eines 160 nm dicken PET-Films auf Silizium-Wafer bei 193 nm im Vakuum mit einer Fluenz von 3 mJ/cm$^2$ und 1000 Pulsen erzeugt. Bei Bestrahlung in Luft ergeben sich ähnliche Ergebnisse.

Die in Figur 3 gezeigte Oberfläche wurde durch Bestrahlen einer 50 $\mu$m dicken Mylar-PET-Folie bei 248 nm in Luft mit polarisierter UV-Strahlung einer Energiedichte von 7,5 mJ/cm$^2$ zweifach sukzessive mit je 1000 Pulsen, also insgesamt mit 2000 Pulsen, bestrahlt, wobei die Probe zwischen der 1. und 2. Bestrahlung um 90 Grad gedreht wurde, so daß die Polarisationsebenen beider Bestrahlungen senkrecht aufeinander standen.

Die für das erfindungsgemäße Verfahren eingesetzten Excimerlaser sind bekannt. Die geeigneten Wellenlängen sind im Bereich von 150 bis 400 nm, wobei insbesondere der (KrF)-Laser mit einer Wellenlänge von 248 nm und der (ArF)-Laser mit einer Wellenlänge von 193 nm bevorzugt sind. Dabei wird die Oberfläche des PET-Materials mit einer unterhalb der Ablationsschwelle sich befindenden Energiedichte, die bei 248 nm im Bereich zwischen 4 und 15 mJ/cm$^2$ und bei 193 nm im Bereich zwischen 3 und 6 mJ/cm$^2$ liegt, mit 100 bis 4000 Pulsen, vorzugsweise 500 bis 2000 Pulsen, mit polarisierter UV-Strahlung zweimal bestrahlt, wobei beide Bestrahlungen zeitlich aufeinanderfolgen und mit in einem Winkel von 20 bis 90°, vorzugsweise senkrecht zueinander stehenden Polarisationsebenen durchgeführt werden.

Zur Erzeugung der polarisierten UV-Strahlung wird der verwendete Excimerlaser mit einem Polarisator versehen. Bei ihrem Einsatz für das erfindungsgemäße Verfahren beträgt die Repeticionsrate der Laser zwischen 1 und 1000 Hz, geeignete Pulslängen sind 10 bis 100 ns.

Die erfindungsgemäß gekennzeichneten PET-Materialien sowie die nach dem erfindungsgemäßen Verfahren erhaltenen feinrauhen Oberflächen finden Anwendung im Zusammenhang mit der Konditionierung von PET-Folien. Sie zeichnen sich außerdem durch eine einheitliche Oberfläche mit gleichmäßigen Eigenschaften aus.

Solcherart ausgestattete PET-Folien eignen sich in hervorragender Weise vor allem als Substratmaterial im Rahmen der Herstellung magnetischer Aufzeichnungsträger, welche eine kohärente ferromagnetische Metalldünnschicht als Magnetschicht aufweisen. Diese Metallschichten werden mit Hilfe von PVD-Verfahren auf das Trägermaterial aufgebracht, wobei jedoch die Ausbildung der Oberfläche des Substratmaterials ein wesentlicher, qualitätsbestimmender Faktor für die Haftung der Schicht auf dem Träger und den Verschleiß der Schicht durch die tribologische Beanspruchung des Magnetkopfes ist.

Für die Verwendung der erfindungsgemäßen PET-Materialien sei beispielhaft auf die Herstellung dieser magnetischen Dünnschichtmedien eingegangen. Hierbei werden die als Folienbahnen eingesetzten PET-Substrate nach dem erfindungsgemäßen Verfahren der UV-Strahlung eines entsprechenden Excimer-Lasers ausgesetzt. Auf ein solchermaßen vorbehandeltes Substrat wird nun in bekannter Vorgehensweise die kohärente ferromagnetische Metalldünnschicht aufgebracht. Geeignete Metallschichten sind im allgemeinen Kobalt-haltig, wie z.B. Co-Ni-Cr, Co-Pt, Co-Ni-O, Co-Cr. Bevorzugt sind Kobalt-Chrom-Schichten mit 15 bis 35 At% Cr, Kobalt-Nickel-Schichten mit mehr als 10 At% Nickel oder Kobalt-Nickel-Sauerstoff-Schichten mit mehr als 10 At% Nickelanteil und zwischen 3 und 45 At% Sauerstoff. Jedoch sind auch entsprechende Metalldünnschichten auf Basis Eisen bekannt und angewandt. Die Herstellung dieser Schichten geschieht mit Hilfe eines PVD-Verfahrens, d.h. z.B. durch Verdampfen, Elektronenstrahlverdampfen, Sputtern, Ionenplattieren oder Beschichtung der Metallkomponenten mit Lichtbogenverfahren. Bevorzug sind das Aufdampfen und Sputtern. Die auf diese Weise hergestellten ferromagnetischen Metallschichten sind zwischen 20 und 500 nm dick. Im Falle von Unterschichten werden Schichtdicken von 2 bis 300 nm bevorzugt. Die Dicke von Schutzschichten zur Verbesserung der Abriebs- und Korrosionsstabilität liegt zwischen 1 und 100 nm. Bekannt ist hier das Aufbringen einer Kohlenstoffschicht, das oberflächliche Oxidieren der Metallschicht, das Beschichten mit flüssigen Oligomeren meist auf Basis von Fluor-haltigen Polyethern, das Bilden von Oxiden, Nitriden oder Carbiden des Bors, Siliciums, Zirkons, Hafniums und Titans oder Kombinationen dieser Maßnahmen.

Die unter Verwendung der erfindungsgemäßen PET-Materialien bzw. des erfindungsgemäßen Verfahrens erhaltenen magnetischen Aufzeichnungsträger zeichnen sich durch eine erhöhte Haftung der Metallschicht auf dem Polymerfilm und durch eine Verminderung der Reibung sowie eine Verbesserung im Standbildverhalten aus. Dies sei an den nachfolgenden Beispielen gezeigt.

Generell gilt, daß das erfindungsgemäße Verfahren zur Erzeugung der spezifischen feinrauhen Oberfläche auf dem PET-Material sich dadurch auszeichnet, daß die Aufrauhung durch die UV-Bestrahlung in einem einzigen Prozeßschritt durchgeführt wird. Dies geschieht durch die Verwendung von zwei hintereinandergeschalteten Lasern mit in einem Winkel von 20 bis 90° zueinander angeordneten, vorzugsweise senkrecht aufeinanderstehenden Polarisationsebenen, um das mechanische Drehen der Probe oder des Polarisators, das einen langsamen diskontinuierlichen Prozeß bedingen würde, zu vermeiden und so einen hohen Durchsatz im kontinuierlichen Betrieb zu ermöglichen. Außerdem wurde dabei nur die Oberfläche der Folie verändert, während der Rest der Folie nicht durch thermische, chemische oder mechanische Belastungen beschädigt wird. Wegen des Einsatzes geringer Energiedichten und kurzer Behandlungsdauern ist es möglich, große Flächen bei erhöhtem Durchsatz gleichmäßig zu bestrahlen.

Im Falle des Einsatzes des erfindungsgemäßen Verfahrens bei der Herstellung von magnetischen Dünnschichtmedien ist es außerdem von Vorteil, daß die Herstellung der Oberflächenrauhigkeit der PET-Folien direkt vor einem weiteren Verarbeitungsschritt, z.B. dem Aufbringen einer ferromagnetischen Metalldünnschicht, in ein und derselben Prozeßkammer durchgeführt werden kann. Eine solche in-situ-Vorbehandlung gewährleistet, daß eine Alterung oder Verschmutzung der aufgerauhten Oberfläche nicht auftritt und, da die Strahlungsquelle außerhalb der Prozeßkammer angebracht ist, eine leichte Steuer- und Kontrollierbarkeit des Substratvorbehandlungsprozesses gewährleistet wird.

Beispiel 1

Eine handelsübliche PET-Folie (Mylar der Fa. DuPont) wurde in Luft bei 193 nm mit einer Energiedichte von 3,9 mJ/cm$^2$ und 1000 Pulsen mit linear polarisierter UV-Strahlung bestrahlt. Elektronenmikroskopische Aufnahmen zeigen eine quasiperiodische Wellen- oder Rollenstruktur mit einem Abstand zwischen diesen rollenförmigen Erhebungen im Bereich von 150 nm. Mit steigender Wellenlänge wird der mittlere Abstand zwischen den Wellen größer, so beträgt er bei 248 nm etwa 200 nm. Da mit polarisierter Strahlung gearbeitet wird, weisen die Wellen entsprechend der Polarisationsebene des UV-Lichts eine Vorzugsrichtung auf und verlaufen annähernd parallel zueinander (siehe Figur 2).

Die Probe wurde anschließend um 90 Grad gedreht und unter Verwendung des gleichen Aufbaus und der gleichen Paramter erneut bei 3,9 mJ/cm$^2$ mit 1000 weiteren Pulsen bestrahlt. Elektronenmikroskopische Aufnahmen zeigen ein noppenförmiges Muster feiner, voneinander isolierter Erhebungen, deren Durchmesser um 100 nm betragen und deren Flächendichte 10 bis 20 Noppen/$\mu$m$^2$ beträgt.

Die Strukturen werden sowohl bei Bestrahlung in Luft als auch im Vakuum erzeugt, solange die Energiedichte im angegebenen Bereich liegt. Außerhalb dieses Fensters der möglichen Energiedichten werden unterhalb der Ablationsschwelle keine solchen Strukturen, weder ripples noch dots, gefunden. Über die Anzahl der eingestrahlten Pulse kann die vertikale Höhe der Noppen gesteuert und somit gezielt eingestellt werden. Damit sind diese hier gefundenen feinen dots grundsätzlich verschieden von den viel zu groben Noppen, die oberhalb der Ablationsschwelle schon bei Verwendung sehr viel weniger Pulse auftreten.

Tabelle 1 faßt die Ergebnisse zusammen. Sämtliche Bestrahlungen erfolgten an Luft. Substrat ist Mylar 200 D-PET-Folie.

**Tabelle 1**

| Wellenlänge | Fluenz | Polarisations-richtung | Zahl der Pulse | Ergebnis |
|---|---|---|---|---|
| 193 nm | 3,9 mJ/cm² | horizontal | 1000 | horizontale ripples |
| 193 nm | 3,9 mJ/cm² | horizontal | 600 | horizontale ripples (schwach) |
| 193 nm | 3,9 mJ/cm² | horizontal | 2000 | horizontale ripples (stark) |
| 193 nm +193 nm | 3,9 mJ/cm² / 3,9 mJ/cm² | horizontal / vertikal | 1000 / 1000 | dot pattern |
| 193 nm +193 nm | 3,9 mJ/cm² / 3,9 mJ/cm² | horizontal / vertikal | 600 / 600 | dot pattern (schwach) |
| 193 nm | 3,9 mJ/cm² | vertikal | 1000 | vertikale ripples |
| 193 nm +193 nm | 3,9 mJ/cm² / 3,9 mJ/cm² | vertikal / horizontal | 1000 / 1000 | dot pattern |
| 193 nm | 3,9 mJ/cm² | vertikal | 600 | vertikale ripples (schwach) |
| 193 nm +193 nm | 3,9 mJ/cm² / 3,9 mJ/cm² | vertikal / horizontal | 600 / 600 | dot pattern (schwach) |

Tabelle 2 listet die kleinsten und größten Fluenzen, für die nach 1000 Pulsen mit 3 Hz Repetitionsrate noch periodische Strukturen beobachtet wurden. Als Substrate wurden kommerzielle Mylar-PET-Folien (10 μm bis 50 μm dick) sowie dünne PET-Filme (100 nm bis 170 nm dick) auf Silizium-Wafern verwendet.

Tabelle 2

|  | 193 nm min Fluenz max Fluenz | 248 nm min Fluenz max Fluenz |
|---|---|---|
| Mylar | 3,5 mJ/cm$^2$ 5,5 mJ/cm$^2$ | <10 mJ/cm$^2$ 14,8 mJ/cm$^2$ |
| PET-Film | 3 mJ/cm$^2$ 5 mJ/cm$^2$ | 4 mJ/cm$^2$ 10,5 mJ/cm$^2$ |

Die erzeugten Strukturen sind hitzebeständig bis 140 °C.

Beispiel 2

In einer handelsüblichen Sputteranlage wurden 200 nm dicke Cr-Unterschichten, anschließend 50 nm dicke (Co-Ni-Cr)-Schichten und endlich 20 nm dicke Kohlenstoffschutz schichten auf 50 $\mu$m dicke PET-Folien (Mylar 200D der Fa. DuPont) im Ar-Plasma gesputtert. Die PET-Folien wurden entweder vor der Beschichtung keiner Vorbehandlung unterzogen oder mit einem Excimerlaser bei einer Wellenlänge von 248 nm mit Energiedichten von 10 bis 15 mJ/cm$^2$ und je 1000 Pulsen in jeder der beiden Polarisationsrichtungen gemäß dem erfindungsgemäßen Verfahren bestrahlt.

An den jeweils erhaltenen Mustern wurden in einem Peeltest (inverser 180°-EAA-Peeltest; P. Phuku, P. Bertrand, Y. De Puydt, Thin Solid Films, 200 (1991), 263) die Schälkraft als Maß für die Haftfestigkeit bestimmt. Dabei zeigte es sich, daß eine nicht bestrahlte Probe eine Haftung von 3 N/cm aufwies, während bestrahlte Proben die maximal meßbare Schälkraft von 4,5 H/cm aufwiesen, d.h. die Haftung wird durch die Bestrahlung so weit verbessert, daß die obere Testgrenze des Peeltests erreicht wird.

Beispiel 3

Verminderung der Reibung

Es wurde wie in Beispiel 2 verfahren, und eine PET-Folie mit einem KrF-Excimerlaser (248 nm) bei 7,5 mJ/cm$^2$ und 1000 Pulsen in jeder Polarisationsrichtung bestrahlt und anschließend die Cr-Unterschicht und die (Co-Ni-Cr)-Magnetschicht gesputtert. Bei der Messung des superquasistatischen Reibkoeffizienten (SQR) zeigte sich, daß das UV-vorbehandelte Medium einen um ca. 20 % verringerten Reibkoeffizienten aufwies als eine unbehandelte, aber ansonsten gleich aufgebaute Referenzprobe.

Beispiel 4

Verbesserung des Verschleißverhaltens

Zur Beurteilung der Auswirkung der UV-Vorbehandlungen auf die tribologischen Eigenschaften wurden an (Co-Ni-Cr)-Schichten mit Cr-Unterschichten auf vorbehandelten Mylar-Folien Standbildmessungen durchgeführt. Dabei wird zunächst ein Signal (10 kfci) auf das Medium aufgezeichnet und dann auf einem Trommeltester, bei dem der feststehende Magnetkopf mit dem sich unter ihm drehenden und kreisförmig eingespannten Medium in Kontakt steht, der Pegelabfall über der Zeit verfolgt. Es wird ein mit der Zeit monoton abfallendes Lesesignal registriert, bis die Magnetschicht vollständig bis auf die Folie durchgerieben ist und kein Lesesignal mehr nachweisbar ist. Mylar 200 D-PET-Folien (Innenseite) wurden bei 193 um mit dem Excimerlaser vorbehandelt und anschließend eine 200 um dicke Cr-Unterschicht und darauf eine 50 nm dicke (Co-Ni-Cr)-Schicht gesputtert. Die gewählte Laserfluenz betrug 3,9 mJ/cm$^2$. Die Bestrahlung erfolgte in beiden Polarisationsrichtungen mit jeweils 600 und 1000 Pulsen, so daß sich jeweils punktförmige Noppenstrukturen ausbildeten. Die Schichten wurden mit Fomblin Z-DOL lubriziert und dem Standbildtest unterzogen. Gegenüber unbestrahlten Referenzproben ergeben sich längere Standzeiten bei deutlich verringertem Pegelabfall. Auf bestrahlten Flächen sind bis zum vollständigen Durchreiben der Schicht erheblich mehr Umläufe möglich als auf den bestrahlten Flächen derselben Probe.

Während auf unbestrahlten Flächen Standzeiten bis zum vollständigem Verschwinden des Pegels von oft nur wenigen Minuten oder weniger beobachtet werden, können auf bestrahlten Flächen Standzeiten von mehreren Stunden erzielt werden. Das Lesesignal ist dabei auf den bestrahlten Flächen durchweg größer als auf den nicht vorbehandelten Flächen. Lichtmikroskopische Aufnahmen zeigen auf unbestrahlten Flächen entlang der Kopfspur Abplatzungen der Magnetschicht. Insbesondere am Rande der Spur, wo besonders hohe Scherkräfte wirken und die Schicht hohen Beanspruchungen ausgesetzt ist, kommt es auf nichtbestrahlten Proben häufig zu großflächigen Ablösungen der Schicht. Diese Zerstörungen machen das Medium völlig unbrauchbar und der Pegel sinkt abrupt auf Null ab. Auf bestrahlten Flächen ist der Abrieb deutlich geringer und es finden sich im Lichtmikroskop keine Anzeichen mechanischer Schädigungen oder Zerstörungen entlang der Kopfspur.

Aufgrund der verbesserten Haftung der Schacht hält das Medium weit größeren Scherkräften am Interface stand und die verminderte Reibung verringert das Spannungsfeld und führt zu einer verminderten Krafteinleitung bei der tribologischen Beanspruchung durch den Kopf.

Damit ist gezeigt, daß die durch UV-Bestrahlung auf der Oberfläche von PET erzeugten feinen Rauhigkeiten in Form von Noppen zu verbessertem Standbildverhalten führen, während die unbehandelten glatten Folien aufgrund der großen Kontaktfläche mit dem Kopf zum Kleben neigen, wodurch die Schicht schnell zerstört wird und sie daher völlig unzureichende Verschleißeigenschaften aufweisen.

**Patentansprüche**

1. Flächiges Polyethylenterephthalat-Material mit einer geringen Oberflächenrauhigkeit, dadurch gekennzeichnet, daß die Oberflächenrauhigkeit aus diskreten, isolierten, noppenförmigen, quasiperiodischen Strukturen im Submikronbereich bestehen mit lateralen Ausdehnungen der noppenförmigen Erhebungen zwischen 10 und 200 nm.

2. Flächiges Polyethylenterephthalat-Material gemäß Anspruch 1, dadurch gekennzeichnet, daß der mittlere Abstand zwischen den einzelnen Noppen nicht mehr als 0,5 $\mu$m beträgt.

3. Verfahren zur Herstellung von geringen Oberflächenrauhigkeiten auf flächigem Polyethylenterephthalat-Material, dadurch gekennzeichnet, daß die Oberflächenrauhigkeit aus noppenförmigen Strukturen im Submikronbereich mit Durchmessern zwischen 10 und 200 nm hergestellt wird durch zweifaches, hintereinander ausgeführtes Bestrahlen mit linear polarisierter UV-Strahlung wobei die Polarisationsebenen der beiden zeitlich hintereinander erfolgenden Bestrahlungen eines gepulsten Excimerlaser im Wellenlängenbereich von 150 nm bis 400 nm zueinander einen Winkel von 20 bis 90° bilden.

4. Verfahren gemäß Anspruch 3, dadurch gekennzeichnet, daß die linear polarisierte UV-Strahlung mit einem gepulsten, mit einem Polarisator ausgerüsteten UV-Excimerlaser erzeugt wird.

5. Verfahren gemäß Anspruch 3, dadurch gekennzeichnet, daß jede der beiden sukzessiv durchgeführten Einzelbestrahlungen bei einer Wellenlänge von 248 nm mit einer Energiedichte von 1 bis 15 mJ/cm$^2$ und einer Pulszahl von größer 200 Pulsen pro Fläche erfolgt.

6. Verfahren gemäß Anspruch 3, dadurch gekennzeichnet, daß jede der beiden sukzessiv durchgeführten Einzelbestrahlungen bei einer Wellenlänge von 193 nm mit einer Energiedichte von 1 bis 6 mJ/cm$^2$ und einer Pulszahl größer als 200 Pulsen pro Fläche erfolgt.

7. Verwendung eines gemäß dem Verfahren nach Anspruch 3 mit geringen Oberflächenrauhigkeiten versehenen Polyethylenterephthalat-Films als polymeres Trägermaterial für eine mittels eines PVD-Verfahrens aufgebrachte kohärente, ferromagnetische Metalldünnschicht.

Abb. 1

Abb. 2

Abb. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| X<br>Y<br>A | GB-A-2 233 334 (EXITECH LTD)<br>* Seite 3, Zeile 9 - Zeile 36 *<br>* Seite 5, Zeile 6 - Zeile 9; Ansprüche 1-3,11 *<br>--- | 1,2<br>3-6<br>7 | B29C59/16<br>//B29K67:00 |
| D,Y | APPLIED PHYSICS LETTERS<br>Bd. 60, Nr. 6 , 10. Februar 1992 , NEW YORK US<br>Seiten 674 - 676<br>M. BOLLE, S. LAZARE, M. LE BLANC, A. WILMES 'Submicron periodic structures produced on polymer surfaces with polarized excimer laser ultraviolet radiation'<br>* Seite 674, linke Spalte, Absatz 2 - Seite 675, linke Spalte, Zeile 1 *<br>--- | 3-6 | |
| P,X | JOURNAL OF APPLIED PHYSICS<br>Bd. 73, Nr. 7 , 1. April 1993 , NEW YORK US<br>Seiten 3516 - 3524<br>M. BOLLE, S. LAZARE 'Characterization of submicrometer periodic structures produced on polymer surfaces with low-fluence ultraviolet laser radiation'<br>* Seite 3520, rechte Spalte, Zeile 2 - Zeile 3 *<br>* Seite 3522, rechte Spalte, Absatz 1; Abbildung 8 *<br>--- | 1-6 | |
| A | EP-A-0 346 485 (TEIJIN PETROCHEMICAL INDUSTRIES LTD. ET AL)<br>* Seite 8, Zeile 17 - Zeile 28 *<br>* Seite 9, Zeile 22 - Seite 12, Zeile 18 *<br>* Seite 16, Zeile 19 - Zeile 22; Ansprüche 1-4 *<br>---<br>-/-- | 1-7 | |

RECHERCHIERTE SACHGEBIETE (Int.Cl.5)

B29C

Der vorliegende Recherchenbericht wurde für alle Patentansprüche erstellt

| Recherchenort | Abschlußdatum der Recherche | Prüfer |
|---|---|---|
| DEN HAAG | 6. Dezember 1993 | Van Nieuwenhuize,O |

Europäisches Patentamt

Nummer der Anmeldung

EP 93 11 2112

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | EP-A-0 098 917 (INTERNATIONAL BUSINESS MACHINES CORPORATION) <br> * Seite 1, Absatz 4 * <br> * Seite 11, Zeile 7 - Zeile 14; Ansprüche 1,2,4,7,8 * <br> --- | 1,3,7 | |
| A | US-A-4 868 006 (E.M. YORKGITIS ET AL) <br> * Spalte 17, Zeile 57 - Zeile 68; Ansprüche 1,11; Beispiele 1,2 * <br> ----- | 1 | |
| | | | RECHERCHIERTE SACHGEBIETE (Int.Cl.5) |

Der vorliegende Recherchenbericht wurde für alle Patentansprüche erstellt

| Recherchenort | Abschlußdatum der Recherche | Prüfer |
|---|---|---|
| DEN HAAG | 6. Dezember 1993 | Van Nieuwenhuize,O |

EPO FORM 1503 03.82 (P04C03)